# EUROPEAN PATENT APPLICATION

(11) **EP 4 024 831 A1**
(43) Date of publication of application: **06.07.2022**
(21) Application number: 20876802.8
(22) Date of filing: 22.09.2020
(51) Int. Cl.: H04M 1/02

(54) **SCREEN ASSEMBLY OF ELECTRONIC DEVICE, AND ELECTRONIC DEVICE**

(30) Priority: 16.10.2019 CN 201910983586
(71) Applicant: GUANGDONG OPPO MOBILE TELECOMMUNICATIONS CORP., LTD., Dongguan, Guangdong 523860 (CN)
(72) Inventor: BAO, Xiaoming, Dongguan, Guangdong 523860 (CN)
(74) Representative: Manitz Finsterwald Patent- und Rechtsanwaltspartnerschaft mbB
(86) International application number: PCT/CN2020/116890
(87) International publication number: WO 2021/073374

(57) **Abstract**

A screen assembly (102) of an electronic device (100), and the electronic device (100). The screen assembly (102) comprises a camera (110), a display assembly (120), and an annular trace region (130). The display assembly (120) comprises a cover plate (121), an optical adhesive layer (1211), a polarizer (122), upper glass (123), lower glass (124), and a foam layer (125) that are arranged in a stacked manner. The polarizer (122) is provided with a first light-transmissive hole (1221). The foam layer (125) is provided with a second light-transmissive hole (1251) opposite the first light-transmissive hole (1211). The annular trace region (130) is arranged on the upper surface of the upper glass (123). An inner wall of the first light-transmissive hole (1211) is located on the radial outer surface of an inner annulus edge (131).

## Description

### CROSS REFERENCE

This application is based on and claims priority of Chinese Patent Application No. 201910983586.0, filed on October 16, 2019, the contents of which are incorporated herein by reference.

### TECHNICAL FIELD

The present disclosure relates to the field of communication devices technologies, and in particular, to a screen assembly of an electronic device, and an electronic device.

### BACKGROUND

Smart phones have ushered in the complete explosion of "full screen" in recent years, allowing many new products to gain a greater vision while maintaining the same size. "Bangs-notched Screen" and "Water-drop-notched Screen" have become the main theme in the field of smartphones, making the "screen-to-body ratio" parameter the battlefield for future new product competitions. After "Bangs-notched Screen", "Hole-notched Screen" will become one of the more widespread full-screen solutions.

The "Hole-notched Screen" is to define a through hole or blind hole on the screen, compared with the "Bangs-notched Screen", defining a hole on the screen is more conducive to increase the screen display area, i.e., the "screen-to-body ratio", to provide a more stunning display effect. However, the existence of the hole leads to lack of display at the hole. Especially when the hole is large, the display effect of the screen is adversely affected.

### SUMMARY OF THE DISCLOSURE

The present disclosure provides a screen assembly of an electronic device. The screen assembly of the electronic device has the advantages of simple structure and good visual effects.

The present disclosure provides a screen assembly of an electronic device, comprising: a camera; a display assembly, comprising a cover, an optical adhesive layer, a polarizer, an upper glass, a lower glass, and a foam layer stacked in order from a top to a bottom; wherein the polarizer defines a first light through hole, and the foam layer defines a second light through hole, the first light through hole facing the second light through hole; the camera is arranged under the display assembly; and a circular wiring area, arranged on an upper surface of the upper glass and comprising an inner ring edge and an outer ring edge; wherein an inner wall of the first light through hole is arranged at a radially outer side of the inner ring edge; wherein light is suitable for passing from the cover, the optical adhesive layer, the first light through hole, an inner ring area defined by the inner ring edge, the upper glass, the lower glass, and the second light through hole, and being transmitted to the camera.

In the screen assembly of the electronic device of the embodiments of the present disclosure, the inner wall of the first light through hole is arranged on the radially outer side of the inner ring edge of the circular wiring area. With the first light through hole and the second light through hole, a blind hole structure is formed at the position where the display assembly is facing the camera. The inner wall of the first light through hole is arranged on the radially outer side of the inner ring edge, which can expose a partial structure of the circular wiring area to form a silver edge area. The design of the silver edge area can take advantage of visual differences to reduce the area on the display assembly facing the camera and not displaying images, thereby improving the display effect of the screen assembly.

The present disclosure further provides an electronic device, comprising: a housing; a camera; a display assembly, embedded in the housing and comprising a cover, an optical adhesive layer, a polarizer, an upper glass, a lower glass, and a foam layer stacked in order from a top to a bottom; wherein the polarizer defines a first light through hole, and the foam layer defines a second light through hole, the first light through hole facing the second light through hole; the camera is arranged in the housing and under the display assembly; and a circular wiring area, arranged on an upper surface of the upper glass and comprising an inner ring edge and an outer ring edge; wherein an inner wall of the first light through hole is arranged at a radially outer side of the inner ring edge; wherein light is suitable for passing from the cover, the optical adhesive layer, the first light through hole, an inner ring area defined by the inner ring edge, the upper glass, the lower glass, and the second light through hole, and being transmitted to the camera.

In the electronic device of the embodiments of the present disclosure, the inner wall of the first light through hole is arranged on the radially outer side of the inner ring edge of the circular wiring area. With the first light through hole and the second light through hole, a blind hole structure is formed at the position where the display assembly is facing the camera. The inner wall of the first light through hole is arranged on the radially outer side of the inner ring edge, which can expose a partial structure of the circular wiring area to form a silver edge area. The design of the silver edge area can take advantage of visual differences to reduce the area on the display assembly facing the camera and not displaying images, thereby improving the display effect of the screen assembly.

The additional aspects and advantages of the present disclosure will be partly given in the following description, and partly will become obvious from the following description, or be understood through the practice of the present disclosure.

### BRIEF DESCRIPTION OF THE DRAWINGS

The above and/or additional aspects and advantages of the present disclosure will become obvious and easy to understand from the description of the embodiments in conjunction with the following drawings.
FIG. 1 is a structural schematic view of an electronic device according to an embodiment of the present disclosure.
FIG. 2 is a schematic view of a partial structure of an electronic device according to an embodiment of the present disclosure.
FIG. 3 is a schematic view of another partial structure of an electronic device according to an embodiment of the present disclosure.
FIG. 4 is a schematic exploded view of a partial structure of an electronic device according to an embodiment of the present disclosure.
FIG. 5 is a schematic exploded view of another partial structure of an electronic device according to an embodiment of the present disclosure.
FIG. 6 is a schematic cross-sectional view of an upper glass of an electronic device according to an embodiment of the present disclosure.
FIG. 7 is an exploded view of a camera of an electronic device according to an embodiment of the present disclosure.
FIG. 8 is a schematic cross-sectional view of an electronic device according to an embodiment of the present disclosure.
FIG. 9 is a partial enlarged view of an area A in FIG. 8.

### Reference numerals:

Electronic device 100;
Housing 101;
Screen assembly 102; Area 103 on the display assembly, which corresponds to the camera and does not display images; Main board 104;
Camera 110; Light inlet 111; Bracket 112; Connecting seat 113; Flexible circuit board 114;
Display assembly 120;
Cover 121; Optical adhesive layer 1211;
Polarizer 122; First light through hole 1221;
Upper glass 123; Groove 1231;
Lower glass 124;
Foam layer 125; Second light through hole 1251;
Circular wiring area 130; Inner ring edge 131; Outer ring edge 132;
Silver edge area 141.

### DETAILED DESCRIPTION

The embodiments of the present disclosure are described in detail below. Examples of the embodiments are shown in the accompanying drawings, in which same or similar reference numerals indicate same or similar elements or elements with same or similar functions. The embodiments described below with reference to the accompanying drawings are exemplary, and are only intended to explain the present disclosure, but should not be understood as limiting the present disclosure.

In the description of the present disclosure, it should be understood that orientation or positional relationships indicated by terms "center", "upper", "lower", "front", "rear", "left", "right", "vertical", "horizontal", "top", "bottom", "inner", "outer", etc. are based on the orientation or positional relationships shown in the accompanying drawings and are intended only to facilitate and simplify the description of the present disclosure, and are not intended to indicate or imply that the device or element referred to must have a particular orientation, be constructed and operate in a particular orientation, and therefore are not to be construed as limiting the present disclosure.

It should be noted that the terms "first" and "second" are only intended for descriptive purposes, and cannot be understood as indicating or implying relative importance or implicitly indicating the number of indicated technical features. Thus, the features defined with "first" and "second" may explicitly or implicitly include one or more of these features. Further, in the description of the present disclosure, unless otherwise specified, "plurality" means two or more.

The embodiments of the present disclosure are described in detail below. Examples of the embodiments are shown in the accompanying drawings, in which same or similar reference numerals indicate same or similar elements or elements with same or similar functions. The embodiments described below with reference to the accompanying drawings are exemplary, and are only intended to explain the present disclosure, but should not be understood as limiting the present disclosure.

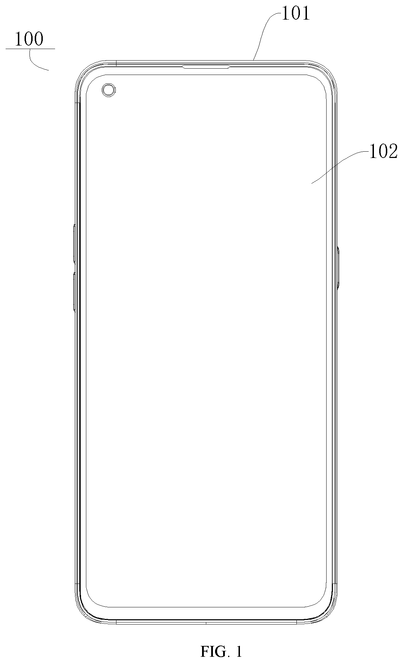

The following describes the screen assembly 102 of the electronic device and the electronic device 100 according to the embodiments of the present disclosure with reference to FIGS. 1-9.

As shown in FIG. 1, the screen assembly 102 of the electronic device according to the embodiments of the present disclosure includes a camera 110 and a display assembly 120.

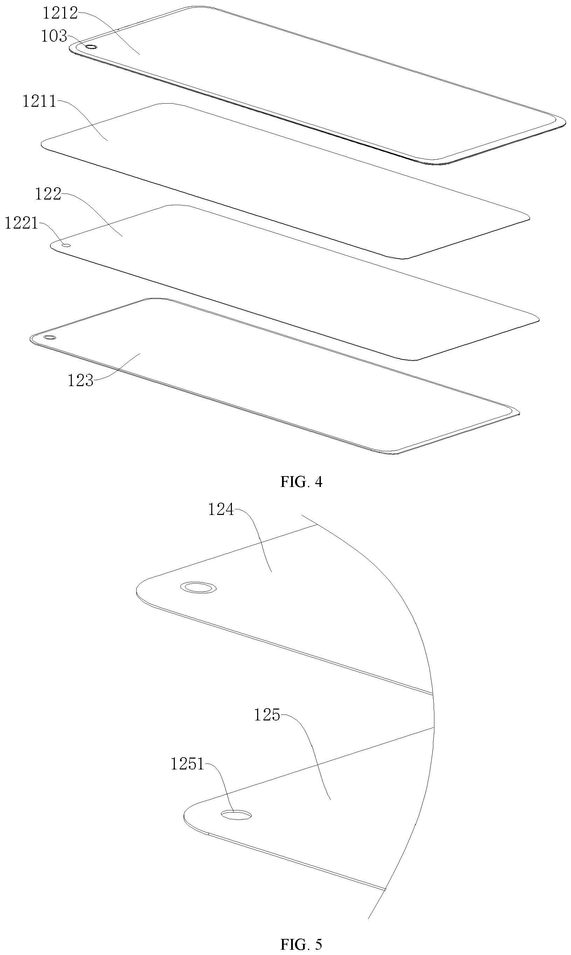

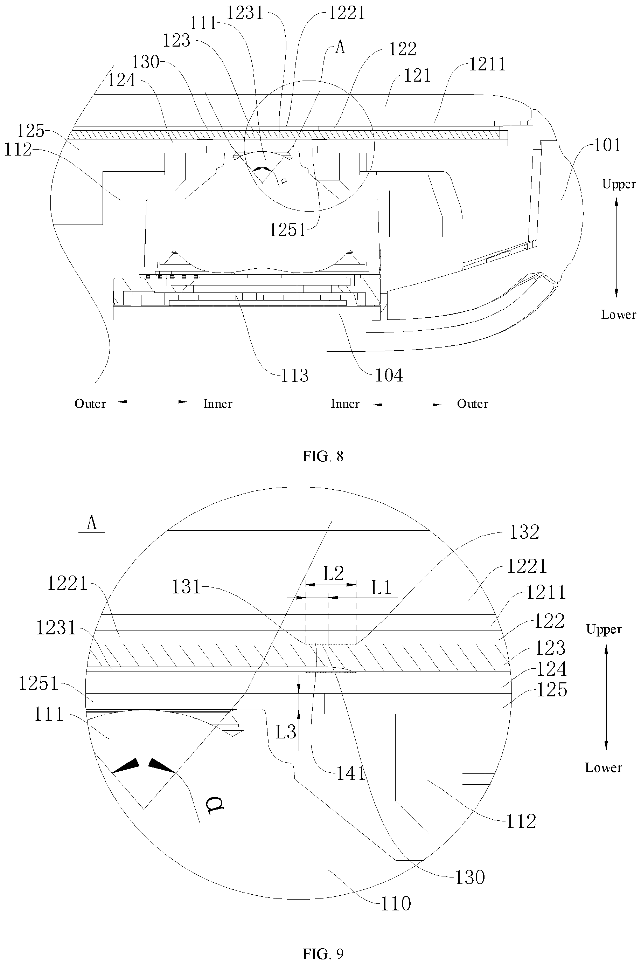

Specifically, as shown in FIG. 8, the display assembly 120 may include a cover 121, an optical adhesive layer 1211, a polarizer 122, an upper glass 123, a lower glass 124, and a foam layer 125 stacked in order from top to bottom. As shown in FIG. 4, the optical adhesive layer 1211 may be configured to bond the cover 121 and the polarizer 122 together. That is, the cover 121 and the polarizer 122 are bonded together, and an adhesive structure between the cover 121 and the polarizer 122 may be the optical adhesive layer 1211. The optical adhesive layer 1211 may be formed by curing glue with a light-transmitting effect. The polarizer 122 defines a first light through hole 1221, the foam layer 125 defines a second light through hole 1251. The first light through hole 1221 faces the second light through hole 1251. As shown in FIG. 8 and FIG. 9, the camera 110 is arranged under the display assembly 120. Further, a light inlet 111 of the camera 110 is defined under the display assembly 120.

When the camera 110 is taking a photo, light may enter the light inlet 111 of the camera 110 through the first light through hole 1221 and the second light through hole 1251, and the camera 110 may perform imaging according to light information. As shown in FIG. 8, an optical axis of the camera 110 is parallel to an axis of the first light through hole 1221 and an axis of the second light through hole 1251. In some embodiments, the optical axis of the camera 110 is collinear with the axis of the first light through hole 1221 and the axis of the second light through hole 1251. It should be noted that by arranging the camera 110 under the display assembly 120, there is no need to reserve an area for the camera 110 on the screen assembly 102 (for example, a water drop structure or a small bangs structure on the screen assembly 102 for placing the camera 110 may be eliminated). Therefore, the screen assembly 102 may have a full-screen structure, that is, a full-screen structure with an under-screen camera 110 may be realized.

It should be noted that the display assembly 120 may be an OLED display screen. The OLED display screen may include the cover 121, the optical adhesive layer 1211, the polarizer 122, the upper glass 123, the lower glass 124, and the foam layer 125. The cover 121 may be a glass cover and configured to protect components under the cover 121. The OLED display screen has a wiring area inside, and metal wires in the wiring area may supply power to the OLED display screen to perform a display function. In order to facilitate the setting of the camera 110, the wiring area may be arranged in a ring structure, that is, the wiring area of the OLED display screen may include a circular wiring area 130. In addition, it should be noted that, the display assembly 120 has an area 103 facing the camera 110 and not displaying images, the circular wiring area 130 is an opaque area, and the circular wiring area 130 may surround an outer periphery of the area 103.

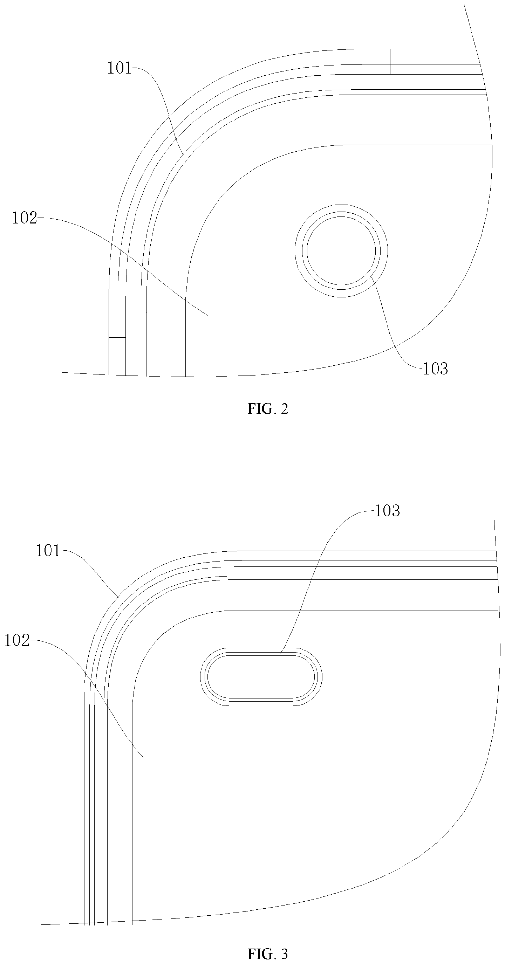

As shown in FIG. 2, the area 103 on the display assembly facing the camera and not displaying images may be circular. Of course, the shape of the area 103 on the display assembly facing the camera and not displaying images is not specifically limited. For example, as shown in FIG. 3, the area 103 on the display assembly facing the camera and not displaying images may be an oblong circle.

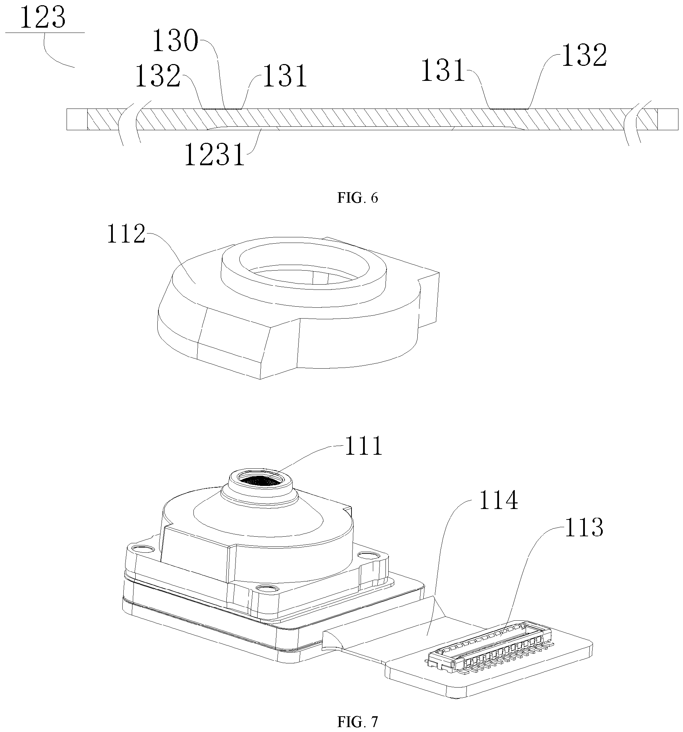

As shown in FIGS. 6, 8 and 9, the circular wiring area 130 is arranged on an upper surface of the upper glass 123. The circular wiring area 130 includes an inner ring edge 131 and an outer ring edge 132. An inner wall of the first light through hole 1221 is arranged at a radially outer side of the inner ring edge 131. Light is suitable for passing from the cover 121, the optical adhesive layer 1211, the first light through hole 1221, an inner ring area defined by the inner ring edge 131, the upper glass 123, the lower glass 124, and the second light through hole 1251 and being transmitted to the camera 110.

In the screen assembly 102 of the electronic device of the embodiments of the present disclosure, the inner wall of the first light through hole 1221 is arranged on the radially outer side of the inner ring edge 131 of the circular wiring area 130. With the first light through hole 1221 and the second light through hole 1251, a blind hole structure is formed at the position where the display assembly 120 is facing the camera 110. The inner wall of the first light through hole 1221 is arranged on the radially outer side of the inner ring edge 131, which can expose a partial structure of the circular wiring area to form a silver edge area 141. The design of the silver edge area 141 can take advantage of visual differences to reduce the area 103 on the display assembly 120 facing the camera 110 and not displaying images, thereby improving the display effect of the screen assembly 102.

In order to further improve the display effect of the screen assembly 102, as shown in FIG. 9, in a radial direction of the circular wiring area 130, a distance between the inner wall of the first light through hole 1221 and the inner ring edge 131 is L1. The value range of L1 is 0.15-0.25mm. It has been verified that when L1=0.2mm, from a visual point of view, the area 103 on the display assembly 120 facing the camera 110 and not displaying images is smaller, and the display effect of the screen assembly 102 is better. Furthermore, the inner wall of the first light through hole 1221 is arranged at the radially inner side of the outer ring edge 132. In other words, the inner wall of the first light through hole 1221 is located between the outer ring edge 132 and the inner ring edge 131.

As shown in FIGS. 8 and 9, the field of view angle of the camera 110 and the display assembly 120 may be α, where α is 79°-82°. It should be noted that the field of view may be related to the width of the circular wiring area 130, the depth of the first through hole 1221, and the depth of the second through hole 1251. By limiting the value range of the field of view, parameter values such as the width of the circular wiring area 130, the depth of the first light through hole 1221, and the depth of the second light through hole 1251 may be optimized to further optimize the structure of the screen assembly 102. It has been verified that when α=80.4°, the structure of the screen assembly 102 is better.

As shown in FIG. 8 and FIG. 9, in the radial direction of the circular wiring area 130, a distance between the inner ring edge 131 and the outer ring edge 132 is L2, where L2 is 0.4-0.5 mm. In other words, the width of the circular wiring area 130 may be 0.4-0.5 mm. It has been verified that when L2=0.45mm, the circular wiring area 130 can meet the use requirements of the screen assembly 102, while capable of reducing the width of the circular wiring area 130, thereby reducing the size of the area 103 on the display assembly 120 facing the camera 110 and not displaying images, and further improving the display effect of the screen assembly 102. In order to further increase the light transmittance of the upper glass 123 and optimize the imaging effect of the camera 110, as shown in FIG. 6 and FIG. 9, a lower surface of the upper glass 123 may define a groove 1231, the groove 1231 facing the second light through hole 1251.

As shown in FIG. 9, an upper surface of the camera 110 is arranged in the second light through hole 1251, such that a height between the camera 110 and the display assembly 120 may be reduced in a vertical direction. Further, as shown in FIG. 9, a distance between the upper surface of the camera 110 and a lower surface of the lower glass 124 is L3, where the L3 is 0.1-0.3 mm. It has been verified that when L3=0.15 mm, the structure of the screen assembly 102 is more compact, and the imaging effect of the camera 110 is better.

As shown in FIG. 1 to FIG. 9, the electronic device 100 according to the embodiments of the present disclosure includes the housing 101, the camera 110, the display assembly 120 and the circular wiring area 130. The display assembly 120 is embedded in the housing 101. The display assembly 120 includes the cover 121, the optical adhesive layer 1211, the polarizer 122, the upper glass 123, the lower glass 124, and the foam layer 125 stacked from top to bottom. The polarizer 122 defines the first light through hole 1221, and the foam layer 125 defines the second light through hole 1251, the first light through hole 1221 facing the second light through hole 1251. The camera 110 is arranged in the housing 101 and under the display assembly 120. As shown in FIG. 8 and FIG. 9, the camera 110 is arranged under the display assembly 120. Further, the light inlet 111 of the camera 110 is defined under the display assembly 120.

When the camera 110 is taking a photo, light may enter the light inlet 111 of the camera 110 through the first light through hole 1221 and the second light through hole 1251, and the camera 110 may perform imaging according to light information. As shown in FIG. 8, an optical axis of the camera 110 is parallel to an axis of the first light through hole 1221 and an axis of the second light through hole 1251. The optical axis of the camera 110 is collinear with the axis of the first light through hole 1221 and the axis of the second light through hole 1251. It should be noted that by arranging the camera 110 under the display assembly 120, there is no need to reserve an area for the camera 110 on the screen assembly 102 (for example, a water drop structure or a small bangs structure on the screen assembly 102 for placing the camera 110 may be eliminated). Therefore, the screen assembly 102 may have a full-screen structure, that is, a full-screen structure with an under-screen camera 110 may be realized.

It should be noted that the display assembly 120 may be an OLED display screen. The OLED display screen may include the cover 121, the optical adhesive layer 1211, the polarizer 122, the upper glass 123, the lower glass 124, and the foam layer 125. The OLED display screen has a wiring area inside, and metal wires in the wiring area may supply power to the OLED display screen to perform a display function. In order to facilitate the setting of the camera 110, the wiring area may be arranged in a ring structure, that is, the wiring area of the OLED display screen may include the circular wiring area 130. In addition, it should be noted that, the display assembly 120 has an area 103 facing the camera 110 and not displaying images, the circular wiring area 130 is an opaque area, and the circular wiring area 130 may surround an outer periphery of the area 103.

As shown in FIGS. 6, 8 and 9, the circular wiring area 130 is arranged on an upper surface of the upper glass 123. The circular wiring area 130 includes an inner ring edge 131 and an outer ring edge 132. An inner wall of the first light through hole 1221 is arranged at a radially outer side of the inner ring edge 131. Light is suitable for passing from the cover 121, the optical adhesive layer 1211, the first light through hole 1221, an inner ring area defined by the inner ring edge 131, the upper glass 123, the lower glass 124, and the second light through hole 1251 and being transmitted to the camera 110.

As shown in FIGS. 7 and 8, the camera 110 may be arranged in the housing 101 through a bracket 112, and the camera 110 may be electrically connected to a main board 104 of the electronic device 100 through the flexible circuit board 114, and a connecting seat 113 arranged on the flexible circuit board 114, such that the light information collected by the camera 110 may be transmitted to the main board 104

In the screen assembly 102 of the electronic device of the embodiments of the present disclosure, the inner wall of the first light through hole 1221 is arranged on the radially outer side of the inner ring edge 131 of the circular wiring area 130. With the first light through hole 1221 and the second light through hole 1251, a blind hole structure is formed at the position where the display assembly 120 is facing the camera 110. The inner wall of the first light through hole 1221 is arranged on the radially outer side of the inner ring edge 131, which can expose a partial structure of the circular wiring area to form a silver edge area 141. The design of the silver edge area 141 can take advantage of visual differences to reduce the area 103 on the display assembly 120 facing the camera 110 and not displaying images, thereby improving the display effect of the screen assembly 102.

In order to further improve the display effect of the screen assembly 102, as shown in FIG. 9, in a radial direction of the circular wiring area 130, a distance between the inner wall of the first light through hole 1221 and the inner ring edge 131 is L1. The value range of L1 is 0.15-0.25mm. It has been verified that when L1=0.2mm, from a visual point of view, the area 103 on the display assembly 120 facing the camera 110 and not displaying images is smaller, and the display effect of the screen assembly 102 is better. Furthermore, the inner wall of the first light through hole 1221 is arranged at the radially inner side of the outer ring edge 132. In other words, the inner wall of the first light through hole 1221 is located between the outer ring edge 132 and the inner ring edge 131.

As shown in FIGS. 8 and 9, the field of view angle of the camera 110 and the display assembly 120 may be α, where α is 79°-82°. It should be noted that the field of view may be related to the width of the circular wiring area 130, the depth of the first through hole 1221, and the depth of the second through hole 1251. By limiting the value range of the field of view, parameter values such as the width of the circular wiring area 130, the depth of the first light through hole 1221, and the depth of the second light through hole 1251 may be optimized to further optimize the structure of the screen assembly 102. It has been verified that when α=80.4°, the structure of the screen assembly 102 is better.

As shown in FIG. 8 and FIG. 9, in the radial direction of the circular wiring area 130, a distance between the inner ring edge 131 and the outer ring edge 132 is L2, where L2 is 0.4-0.5 mm. In other words, the width of the circular wiring area 130 may be 0.4-0.5 mm. It has been verified that when L2=0.45mm, the circular wiring area 130 can meet the use requirements of the screen assembly 102, while capable of reducing the width of the circular wiring area 130, thereby reducing the size of the area 103 on the display assembly 120 facing the camera 110 and not displaying images, and further improving the display effect of the screen assembly 102. In order to further increase the light transmittance of the upper glass 123 and optimize the imaging effect of the camera 110, as shown in FIG. 6 and FIG. 9, a lower surface of the upper glass 123 may define a groove 1231, the groove 1231 facing the second light through hole 1251.

As shown in FIG. 9, an upper surface of the camera 110 is arranged in the second light through hole 1251, such that a height between the camera 110 and the display assembly 120 may be reduced in a vertical direction. Further, as shown in FIG. 9, a distance between the upper surface of the camera 110 and a lower surface of the lower glass 124 is L3, where the L3 is 0.1-0.3 mm. It has been verified that when L3=0.15 mm, the structure of the screen assembly 102 is more compact, and the imaging effect of the camera 110 is better.

In the description of the present disclosure, it should be understood that orientation or positional relationships indicated by terms "center", "length", "upper", "lower", "horizontal", "inner", "outer", "axial", "radial", "circumferential", etc. are based on the orientation or position relationships shown in the accompanying drawings, and are only for the convenience of describing the present disclosure and simplifying the description, rather than indicating or implying that the device or element referred to must have a particular orientation, be constructed and operate in a particular orientation, and therefore are not to be construed as limiting the present disclosure. In the description of the present disclosure, "plurality" means two or more.

In the description of this specification, descriptions with reference to terms "an embodiment", "some embodiments", "exemplary embodiments", "examples", "specific examples", or "some examples" etc. means that the specific features, structures, materials, or characteristics described in connection with the embodiment or example are included in at least one embodiment or example of the present disclosure. In this specification, the schematic representation of the above terms does not necessarily refer to the same embodiment or example. Further, the specific features, structures, materials, or characteristics described may be combined in any one or more embodiments or examples in a suitable manner.

Although the embodiments of the present disclosure have been shown and described, those skilled in the art can understand that various changes, modifications, substitutions and modifications can be made to these embodiments without departing from the principle and purpose of the present disclosure. The scope of the present disclosure is defined by the claims and their equivalents.

In the description of this specification, descriptions with reference to terms "an embodiment", "some embodiments", "exemplary embodiments", "examples", "specific examples", or "some examples" etc. means that the specific features, structures, materials, or characteristics described in connection with the embodiment or example are included in at least one embodiment or example of the present disclosure. In this specification, the schematic representation of the above terms does not necessarily refer to the same embodiment or example. Further, the specific features, structures, materials, or characteristics described may be combined in any one or more embodiments or examples in a suitable manner.

Although the embodiments of the present disclosure have been shown and described, those skilled in the art can understand that various changes, modifications, substitutions and modifications can be made to these embodiments without departing from the principle and purpose of the present disclosure. The scope of the present disclosure is defined by the claims and their equivalents.

## Claims

1. A screen assembly of an electronic device, **characterized by** comprising:
a camera;
a display assembly, comprising a cover, an optical adhesive layer, a polarizer, an upper glass, a lower glass, and a foam layer stacked in order from a top to a bottom; wherein the polarizer defines a first light through hole, and the foam layer defines a second light through hole, the first light through hole facing the second light through hole; the camera is arranged under the display assembly; and
a circular wiring area, arranged on an upper surface of the upper glass and comprising an inner ring edge and an outer ring edge; wherein an inner wall of the first light through hole is arranged at a radially outer side of the inner ring edge;
wherein light is suitable for passing from the cover, the optical adhesive layer, the first light through hole, an inner ring area defined by the inner ring edge, the upper glass, the lower glass, and the second light through hole, and being transmitted to the camera.

2. The screen assembly according to claim 1, wherein, in a radial direction of the circular wiring area, a distance between the inner wall of the first light through hole and the inner ring edge is L1, and a value range of L1 is 0.15-0.25mm.

3. The screen assembly according to claim 2, wherein L1=0.2mm.

4. The screen assembly according to any one of claims 1-3, wherein the inner wall of the first light through hole is arranged at a radially inner side of the outer ring edge.

5. The screen assembly according to any one of claims 1-4, wherein a field of view angle of the camera and the display assembly is α, and a value range of α is 79°-82°.

6. The screen assembly according to claim 5, wherein α=80.4°.

7. The screen assembly according to any one of claims 1-6, wherein in a radial direction of the circular wiring area, a distance between the inner ring edge and the outer ring edge is L2, and a value range of L2 is 0.4-0.5 mm.

8. The screen assembly according to claim 7, wherein L2=0.45mm.

9. The screen assembly according to any one of claims 1-8, wherein a lower surface of the upper glass defines a groove, the groove facing the second light through hole.

10. The screen assembly according to any one of claims 1-9, wherein an upper surface of the camera is arranged in the second light through hole.

11. The screen assembly according to any one of claims 1-10, wherein a distance between an upper surface of the camera and a lower surface of the lower glass is L3, and a value range of L3 is 0.1-0.3 mm.

12. The screen assembly according to claim 11, wherein L3=0.15mm.

13. An electronic device, **characterized by** comprising:
a housing;
a camera;
a display assembly, embedded in the housing and comprising a cover, an optical adhesive layer, a polarizer, an upper glass, a lower glass, and a foam layer stacked in order from a top to a bottom; wherein the polarizer defines a first light through hole, and the foam layer defines a second light through hole, the first light through hole facing the second light through hole; the camera is arranged in the housing and under the display assembly; and
a circular wiring area, arranged on an upper surface of the upper glass and comprising an inner ring edge and an outer ring edge; wherein an inner wall of the first light through hole is arranged at a radially outer side of the inner ring edge;
wherein light is suitable for passing from the cover, the optical adhesive layer, the first light through hole, an inner ring area defined by the inner ring edge, the upper glass, the lower glass, and the second light through hole, and being transmitted to the camera.

14. The electronic device according to claim 13, wherein, in a radial direction of the circular wiring area, a distance between the inner wall of the first light through hole and the inner ring edge is L1, and a value range of L1 is 0.15-0.25mm.

15. The electronic device according to claim 14, wherein L1=0.2mm.

16. The electronic device according to any one of claims 13-15, wherein the inner wall of the first light through hole is arranged at a radially inner side of the outer ring edge.

17. The electronic device according to any one of claims 13-16, wherein a field of view angle of the camera and the display assembly is α, and a value range of α is 79°-82°.

18. The electronic device according to claim 17, wherein α=80.4°.

19. The electronic device according to any one of claims 13-18, wherein in a radial direction of the circular wiring area, a distance between the inner ring edge and the outer ring edge is L2, and a value range of L2 is 0.4-0.5 mm.

20. The electronic device according to claim 19, wherein L2=0.45mm.

21. The electronic device according to any one of claims 13-20, wherein a lower surface of the upper glass defines a groove, the groove facing the second light through hole.

22. The electronic device according to any one of claims 13-21, wherein an upper surface of the camera is arranged in the second light through hole.

23. The electronic device according to claim 22, wherein a distance between an upper surface of the camera and a lower surface of the lower glass is L3, and a value range of L3 is 0.1-0.3 mm.

24. The electronic device according to claim 23, wherein L3=0.15mm.
